# EUROPEAN PATENT APPLICATION

(11) **EP 4 741 211 A1**
(43) Date of publication of application: **13.05.2026**
(21) Application number: 25208365.4
(22) Date of filing: 13.10.2025
(51) Int. Cl.: B60L 15/00, H05K 1/181, H05K 3/28, H05K 3/341, H05K 7/20, H10W 90/00

(54) **SYSTEMS AND METHOD FOR COOLING MODULE FOR POWER CONVERSION SYSTEM FOR ELECTRIC VEHICLE**

(30) Priority: 08.11.2024 US 202418941558
(71) Applicant: Borgwarner Inc., Auburn Hills, Michigan 48326 (US)
(72) Inventor: MAYER, Andreas, Clarkston, MI (US); ADIAMAN, Elanchetchenni, Sterling Heights, MI (US); DOMINGUES, Gabriel, Lund (SE); LOUCO, Lathom Alexander, Arden, NC (US)
(74) Representative: Office Freylinger

(57) **Abstract**

A system includes a power conversion unit, wherein the power conversion unit includes: a power module; and a first cooling module configured to extract heat from the power module, wherein the power module includes: a printed circuit board; a switching power device embedded within the printed circuit board; and a first external isolation layer external to the printed circuit board, wherein the first cooling module directly contacts the first external isolation layer.

## Description

### TECHNICAL FIELD

Various embodiments of the present disclosure relate generally to a cooling module for an inverter, and more specifically, to systems and methods of a cooling module for embedded power devices in power conversion systems in electric vehicles.

### BACKGROUND

Thermal management is considered a key technical aspect in an electric vehicle system. A cooling module may therefore be a critical component in an inverter system, which controls the performance and efficiency of an overall driving system of an electric vehicle. However, some PCB-based power modules with embedded semiconductor chips may require an isolation layer that interrupts an electrical path to an embedded chip built into a PCB, which may significantly reduce heat transfer from the power module to the cooling module.

The present disclosure is directed to overcoming one or more of these above referenced challenges.

### SUMMARY OF THE DISCLOSURE

In some aspects, the techniques described herein relate to a system including a power conversion unit, wherein the power conversion unit includes: a power module; and a first cooling module configured to extract heat from the power module, wherein the power module includes: a printed circuit board; a switching power device embedded within the printed circuit board; and a first external isolation layer external to the printed circuit board, wherein the first cooling module directly contacts the first external isolation layer.

In some aspects, the techniques described herein relate to a system, wherein the first external isolation layer includes a thermal interface material layer and a ceramic isolation layer.

In some aspects, the techniques described herein relate to a system, further including: a second cooling module configured to extract heat from the power module, and wherein the power module includes a second external isolation layer external to the printed circuit board.

In some aspects, the techniques described herein relate to a system, wherein a first side of the first external isolation layer is in contact with the first cooling module and a second side of the first external isolation layer opposite to the first side is in contact with a first end of the printed circuit board, and wherein a first side of the second external isolation layer is in contact with the second cooling module and a second side of the second external isolation layer opposite to the first side is in contact with a second end of the printed circuit board.

In some aspects, the techniques described herein relate to a system, wherein the power module includes a first solder mask layer in contact with the first end of the printed circuit board and a second solder mask layer in contact with the second end of the printed circuit board, and wherein the first external isolation layer is within and/or exterior to the first solder mask layer and the second external isolation layer is within and/or exterior to the second solder mask layer.

In some aspects, the techniques described herein relate to a system, wherein the first cooling module cools the power module via air cooling.

In some aspects, the techniques described herein relate to a system, wherein the first cooling module cools the power module via liquid cooling.

In some aspects, the techniques described herein relate to a system, wherein the liquid cooling includes water-glycol.

In some aspects, the techniques described herein relate to a system, wherein the printed circuit board includes a plurality of conductive layers, and wherein each conductive layer of the plurality of conductive layers is electrically connected to the switching power device.

In some aspects, the techniques described herein relate to a system, wherein the power module is cooled via double-side cooling.

In some aspects, the techniques described herein relate to a system, further including: a battery connected to the power conversion unit, and a motor configured to rotate based on power received from the power conversion unit, wherein the system is provided as a vehicle.

In some aspects, the techniques described herein relate to a system including a first cooling module configured to extract heat from a power module, wherein the power module includes a printed circuit board and a switching power device embedded within the printed circuit board, wherein the power module includes a first external isolation layer external to the printed circuit board, and wherein the first cooling module directly contacts the first external isolation layer.

In some aspects, the techniques described herein relate to a system, wherein the printed circuit board includes a plurality of conductive layers, and wherein each conductive layer of the plurality of conductive layers is electrically connected to the switching power device.

In some aspects, the techniques described herein relate to a system, further including a second cooling module configured to extract heat from the power module, wherein the power module includes a second external isolation layer external to the printed circuit board, wherein a first side of the first external isolation layer is in contact with the first cooling module and a second side of the first external isolation layer opposite to the first side is in contact with a first end of the printed circuit board, and wherein a first side of the second external isolation layer is in contact with the second cooling module and a second side of the second external isolation layer opposite to the first side is in contact with a second side of the printed circuit board.

In some aspects, the techniques described herein relate to a system, wherein the first cooling module cools the power module via liquid cooling.

In some aspects, the techniques described herein relate to a method including: embedding a switching power device within a printed circuit board of a power module; and extracting heat from the power module via a first cooling module, wherein the power module includes a first external isolation layer external to the printed circuit board, and wherein the first cooling module directly contacts the first external isolation layer.

In some aspects, the techniques described herein relate to a method, wherein the printed circuit board includes a plurality of conductive layers, and wherein each conductive layer of the plurality of conductive layers is electrically connected to the switching power device.

In some aspects, the techniques described herein relate to a method, further including: extracting heat from the power module via a second cooling module, wherein the first cooling module is provided at a first end of the power module and wherein the second cooling module is provided at a second end of the power module opposite to the first end, and wherein the power module includes a second external isolation layer external to the printed circuit board.

In some aspects, the techniques described herein relate to a method, wherein a first side of the first external isolation layer is in contact with the first cooling module and a second side of the first external isolation layer opposite to the first side is in contact with the first end of the printed circuit board, and wherein a first side of the second external isolation layer is in contact with the second cooling module and a second side of the second external isolation layer opposite to the first side is in contact with the second end of the printed circuit board.

In some aspects, the techniques described herein relate to a method, wherein the first cooling module cools the power module via air cooling.

In some aspects, the techniques described herein relate to a system including a power conversion unit, wherein the power conversion unit includes: a power module; and a first cooling module configured to extract heat from the power module, wherein the power module includes: a printed circuit board; and a switching power device embedded within the printed circuit board, wherein the first cooling module is directly attached to a first end of the printed circuit board.

In some aspects, the techniques described herein relate to a system, the power module further including: a copper layer at the first end of the printed circuit board, wherein the first cooling module is directly attached to the copper layer.

In some aspects, the techniques described herein relate to a system, further including: a second cooling module configured to extract heat from the power module, wherein the second cooling module is directly attached to a second end of the printed circuit board opposite to the first end of the printed circuit board.

In some aspects, the techniques described herein relate to a system, wherein the first cooling module is encapsulated in a first epoxy mold and the second cooling module is encapsulated in a second epoxy mold.

In some aspects, the techniques described herein relate to a system, wherein the first cooling module and the second cooling module each include one or more cooling channels with a cooling medium.

In some aspects, the techniques described herein relate to a system, wherein the printed circuit board includes a plurality of conductive layers, and wherein each conductive layer of the plurality of conductive layers is electrically connected to the switching power device.

In some aspects, the techniques described herein relate to a system, wherein the printed circuit board includes one or more vias, and wherein the one or more vias and the plurality of conductive layers are used for both electrical routing and thermal dissipation.

In some aspects, the techniques described herein relate to a system, wherein the first cooling module includes: a copper fin structure attached to the printed circuit board; an epoxy mold cover surrounding the copper fin structure; and a dielectric fluid within the epoxy mold cover.

In some aspects, the techniques described herein relate to a system, wherein the printed circuit board includes a plurality of conductive layers, and wherein each conductive layer of the plurality of conductive layers is electrically connected to the switching power device.

In some aspects, the techniques described herein relate to a system, wherein the printed circuit board includes one or more vias, and wherein the one or more vias and the plurality of conductive layers are used for both electrical routing and thermal dissipation.

In some aspects, the techniques described herein relate to a system, further including: a battery connected to the power conversion unit, and a motor configured to rotate based on power received from the power conversion unit, wherein the system is provided as a vehicle.

In some aspects, the techniques described herein relate to a system including a first cooling module configured to extract heat from a power module, wherein the power module includes a printed circuit board and a switching power device embedded within the printed circuit board, wherein the printed circuit board includes a plurality of conductive layers, and wherein each conductive layer of the plurality of conductive layers is electrically connected to the switching power device.

In some aspects, the techniques described herein relate to a system, wherein the first cooling module is directly attached to a first end of the printed circuit board.

In some aspects, the techniques described herein relate to a system, further including a second cooling module configured to extract heat from the power module, wherein the second cooling module is directly attached to a second end of the printed circuit board opposite to the first end of the printed circuit board.

In some aspects, the techniques described herein relate to a system, wherein each of the first cooling module and the second cooling module includes: a copper fin structure attached to the printed circuit board; an epoxy mold cover surrounding the copper fin structure; and a dielectric fluid within the epoxy mold cover, wherein the printed circuit board includes one or more vias, and wherein the one or more vias and the plurality of conductive layers are used for both electrical routing and thermal dissipation.

In some aspects, the techniques described herein relate to a method including: embedding a switching power device within a printed circuit board of a power module; and extracting heat from the power module via a first cooling module, wherein the printed circuit board includes a plurality of conductive layers, and wherein each conductive layer of the plurality of conductive layers is electrically connected to the switching power device.

In some aspects, the techniques described herein relate to a method, further including: directly attaching a fin structure of the first cooling module to a first end of the printed circuit board.

In some aspects, the techniques described herein relate to a method, wherein the printed circuit board includes one or more vias, and wherein the one or more vias and the plurality of conductive layers are used for both electrical routing and thermal dissipation.

In some aspects, the techniques described herein relate to a method, further including: extracting heat from the power module via a second cooling module; and directly attaching a fin structure of the second cooling module to a second end of the printed circuit board opposite to the first end, wherein the first cooling module is encapsulated in an epoxy mold and includes one or more cooling channels with a water-glycol fluid, and wherein the second cooling module includes: an epoxy mold cover surrounding the fin structure; and a dielectric fluid within the epoxy mold cover.

In some aspects, the techniques described herein relate to a method, wherein the printed circuit board includes one or more vias, and wherein the one or more vias and the plurality of conductive layers are used for both electrical routing and thermal dissipation.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including an inverter, according to one or more embodiments.
FIG. 2A depicts an exemplary double-sided cooled PCB-based power module with indirect cooling, according to one or more embodiments.
FIG. 2B depicts an exemplary single-sided cooled PCB-based power module with indirect cooling, according to one or more embodiments.
FIG. 3A depicts an exemplary double-sided cooled power module with direct multi-channel cooling and direct single-channel cooling, according to one or more embodiments.
FIG. 3B depicts an exemplary double-sided cooled power module with direct multi-channel cooling, according to one or more embodiments.
FIG. 3C depicts an exemplary single-sided cooled power module with direct multi-channel cooling, according to one or more embodiments.
FIG. 3D depicts an exemplary double-sided cooled power module with direct single-channel cooling, according to one or more embodiments.
FIG. 3E depicts an exemplary single-sided cooled power module with direct single-channel cooling, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the power module may be described as a device, but may refer to any device for controlling the flow of power in an electrical circuit. For example, a power module may be a metal-oxide-semiconductor field-effect transistor (MOSFETs), bipolar junction transistor (BJTs), insulated-gate bipolar transistor (IGBTs), or relays, for example, or any combination thereof, but are not limited thereto.

Thermal management may be considered a key technical aspect in an electric vehicle system. The interaction between a cooling module and a power module may therefore be critical in a power conversion unit, such as a traction inverter system, which controls the performance and efficiency of an overall driving system of an electric vehicle. Therefore, improved thermal management may be a demanding technology for performance and reliability of traction inverters. However, some PCB-based power modules with embedded power chips require an internal isolation layer that interrupts the electrical path of the embedded power chip for high voltage applications. The internal isolation layer is then between the embedded power device and the cooling module. The internal isolation layer can be placed on only one side of the PCB (e.g., between the embedded chip and the cooling module to ensure the cooling module is electrically insulated from the embedded chip) to allow for high voltage connections, which limits the system to a single-side cooled power module. One or more embodiments may overcome these issues. One or more embodiments may provide an isolation layer external to the power module to allow for double-side cooling. One or more embodiments may directly connect the thermal paths of the power module to the cooling module.

A power module may be embodied as a power chip embedded printed circuit board (PCB). The power chip may be silicon carbide chip that is attached onto a copper block, which is then embedded into a PCB with multiple vias creating electrical connections to the chip. To meet high voltage (e.g., greater than 60 VDC) isolation requirements, the PCB may be required to include adequate creepage, clearance, and isolation. Specifically, the PCB may require a specialized thermal conductive isolation layer included within the PCB to electrically isolate one or more internal conductive layers and/or the cooling module. The cooling module (e.g., a heat sink) may then be attached to the PCB on the side with the isolation layer such that the isolation layer is between the embedded chip and the cooling module.

One or more embodiments may include a single-sided or double-sided cooled PCB power module with an embedded chip attached to a copper core. One or more embodiments may include a single-sided or double-sided cooled PCB power module with an embedded chip that has one or more vias connecting the thermal path of the chip directly to one or more cooling modules. One or more embodiments may provide a cooling module as a heat sink with a cover and a plurality of fins. One or more embodiments may provide a cooling module that is actively cooled with a cooling medium (e.g., dielectric fluid or water-glycol). One or more embodiments may provide a cooling module that is passively cooled with air. One or more embodiments may include a cooling module with fins directly soldered, welded, and/or sintered to the PCB and covered with an epoxy mold. One or more embodiments may include a cooling module that is encapsulated in an epoxy mold with cooling channels. One or more embodiments include a power module without an internal isolation layer that interrupts the electrical path to the cooling module.

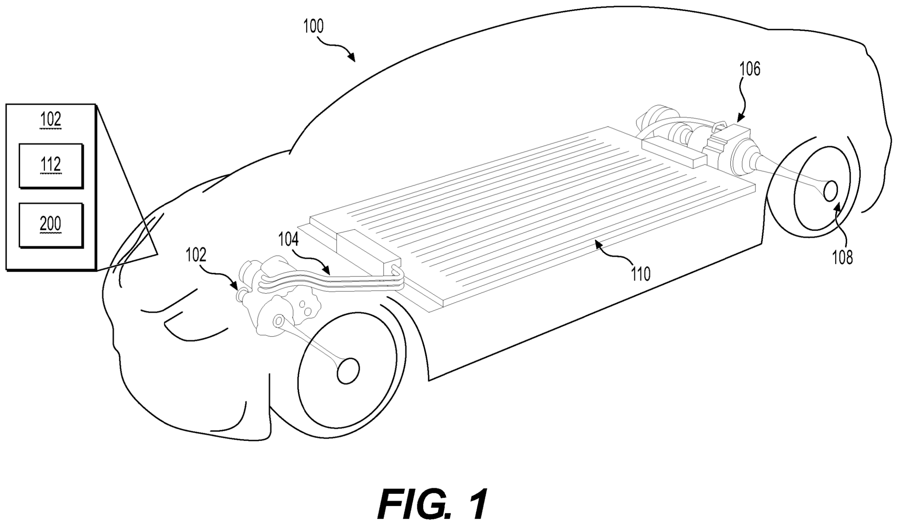

FIG. 1 depicts an exemplary system infrastructure for a vehicle including an inverter, according to one or more embodiments. Electric vehicle 100 may include traction inverter 102, connectors 104, drive motor 106, wheels 108, and battery 110. Traction inverter 102 may include power module 112 and cooling module (e.g., a heat sink system) 200. Cooling module 200 may be used to cool power module 112. Connectors 104 may connect the traction inverter 102 and battery 110. Traction inverter 102 may include components to receive electrical power from an external source and output electrical power to charge battery 110 of electric vehicle 100. Traction inverter 102, through the use of a power module 112, may convert DC power from battery 110 in electric vehicle 100 to AC power, to rotate the drive motor 106 and wheels 108 of electric vehicle 100, for example, but the embodiments are not limited thereto. The traction inverter 102 may be bidirectional, and may convert DC power to AC power, or convert AC power to DC power, such as during regenerative braking, for example. Traction inverter 102 may be a single-phase inverter, or a multi-phase inverter, such as a three-phase inverter, for example.

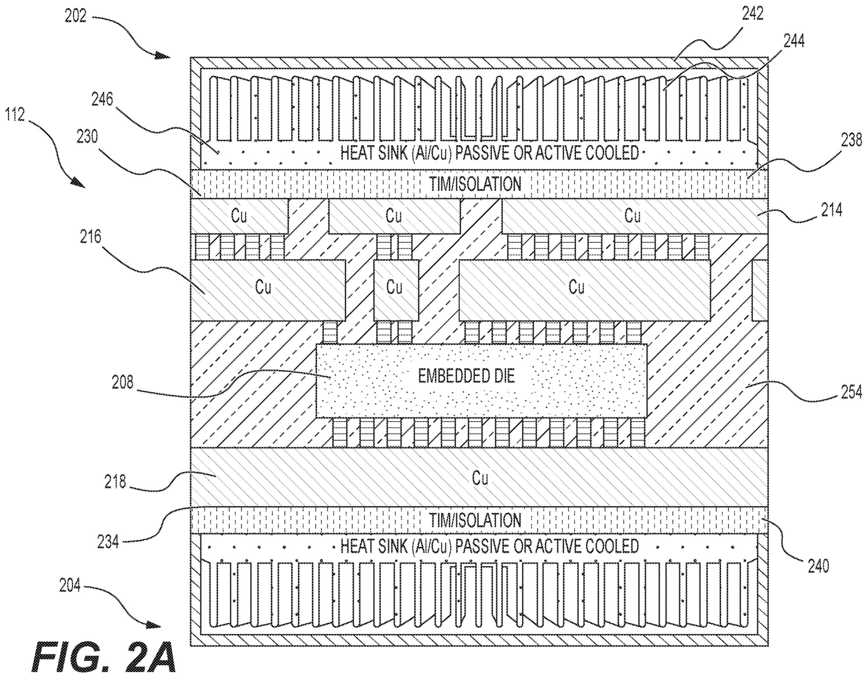

FIG. 2A depicts an exemplary double-sided cooled PCB-based power module with indirect cooling, according to one or more embodiments. Power module 112 may interface with a first cooling module 202 and a second cooling module 204 to extract heat from power module 112. Cooling module 200 may include first cooling module 202 and/or second cooling module 204. Power module 112 may include a switching power device 208. Switching power device 208 may be an embedded chip such as a silicon carbide chip. Switching power device 208 may be attached to a copper block and embedded into power module 112. Switching power device 208 may be fully housed within a PCB. Power module 112 may include one or more conductive layers 214, 216, 218, and 220. Power module 112 may include one or more isolation layers 222, 224, 226, and 228. Power module may include first solder mask layer 232 and second solder mask layer 236.

Each of conductive layers 214, 216, 218, and 220 may be electrically connected to the switching power device 208. For example, conductive layers 214, 216, 218, and 220 may include one or more of a source layer, a drain layer, or a gate control layer. Isolation layers 222, 224, 226, and 228 may electrically isolate the conductive layers 214, 216, 218, and 220 from each other, but do not entirely isolate the conductive layers 214, 216, 218, and 220 from the switching power device 208.

First cooling module 202 may interface with power module 112 at a first end 230 and second cooling module 204 may interface with power module 112 at second end 234, opposite to first end 230. Switching power device 208 may be embedded into power module 112 such that switching power device 208 is fully between (e.g., within) first end 230 and second end 234. Power module 112 may include a first isolation layer 238 in first solder mask layer 232, and a second isolation layer 240 in second solder mask layer 236. As depicted in FIG. 2A, first isolation layer 238 and second isolation layer 240 are not internal to the power module 112, but are instead external to power module 112. First cooling module 202 and second cooling module 204 may contact first isolation layer 238 and second isolation layer 240, respectively. First isolation layer 238 and second isolation layer 240 may each be a ceramic isolation layer with or without a TIM. First isolation layer 238 may be within and/or exterior to first solder mask layer 232 and second isolation layer 240 may be within and/or exterior to second solder mask layer 236. That is, first isolation layer 238 and second isolation layer 240 are not internal to power module 112 between first solder mask layer 232 and second solder mask layer 236.

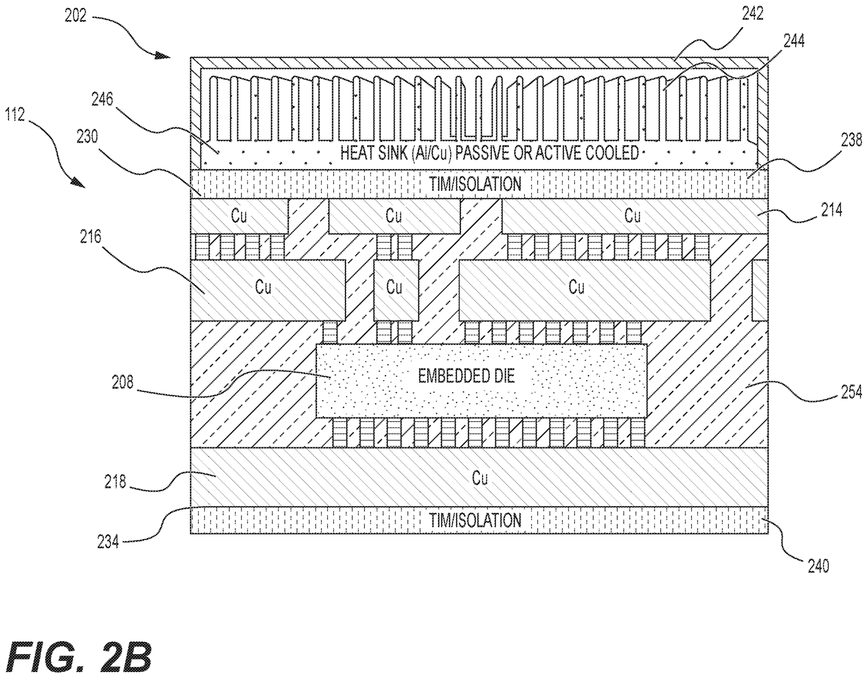

First cooling module 202 and second cooling module 204 may passively or actively cool power module 112. For example, first cooling module 202 and second cooling module 204 may each include a cover 242, a plurality of fins 244, and a base 246. Cover 242 may surround plurality of fins 244 extending from base 246. Thus, first cooling module 202 and second cooling module 204 may each passively cool power module 112 with air. Alternatively or additionally, first cooling module 202 and second cooling module 204 may each actively cool power module 112 with a cooling medium. The cooling medium may be a dielectric liquid or water-glycol. The base 246 may contact first isolation layer 238 or second isolation layer 240. Because first cooling module 202 and second cooling module 204 interface with first isolation layer 238 and second isolation layer 240, respectively, first cooling module 202 and second cooling module 204 may be electrically isolated from switching power device 208, while all of the conductive layers 214, 216, 218, and 220 within power module 112 may be electrically connected to switching power device 208. The power module 112 may be used for high voltage systems (e.g., 60 VDC). Because power module 112 does not include an internal isolation layer that electrically isolates one or more conductive layers from the first cooling module 202 and second cooling module 204, the power module 112 may be double-sided cooled as depicted in FIG. 2A, or single-sided cooled as depicted in FIG. 2B.

FIG. 2B depicts an exemplary single-sided cooled PCB-based power module with indirect cooling, according to one or more embodiments. The power module 250 of FIG. 2B may be substantially similar to the power module 112 of FIG. 2A (e.g., power module 250 may be used in electric vehicle 100). For example, power module 250 may include a cooling module 200, a switching power device 208, , conductive layers 214, 216, 218, and 220, isolation layers 222, 224, 226, and 228, a first end 230 with a first solder mask layer 232 and a first isolation layer 238, and a second end 234 with a second solder mask layer 252. Second solder mask layer 252 may be similar to second solder mask layer 236, except that second solder mask layer 252 may extend over the entirety of power module 250 because there is no cooling module at the second end 234. As described previously with respect to FIG. 2A, conductive layers 214, 216, 218, 220 may be electrically connected to switching power device 208. Power module 250 may interface with first cooling module 202 as a single (i.e. one and only one) cooling module. Therefore, power module 112 may be double-sided cooled while power module 250 may be single-sided cooled.

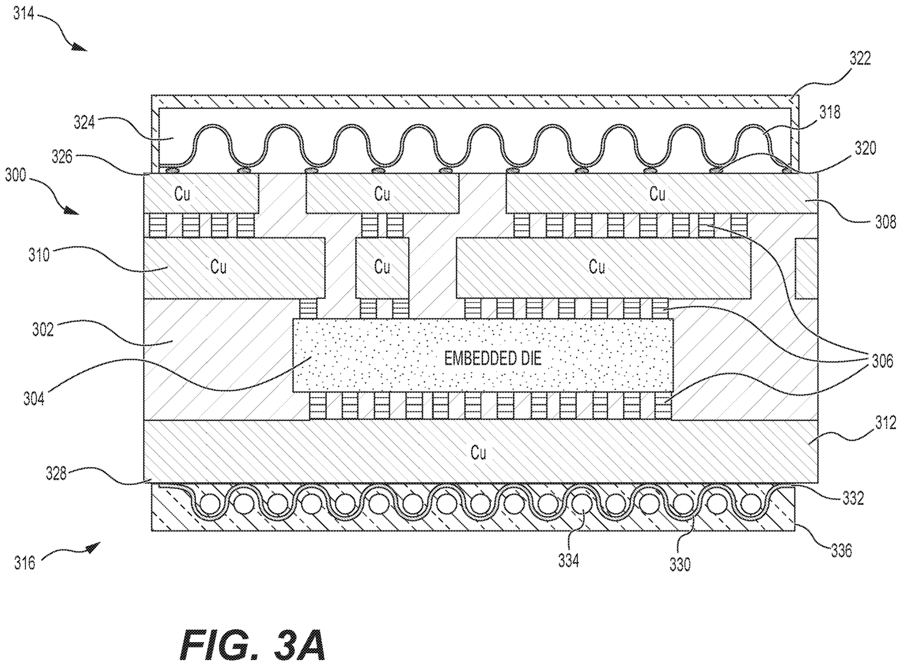

FIG. 3A depicts an exemplary double-sided cooled PCB-based power module with direct multi-channel cooling and direct single-channel cooling, according to one or more embodiments. Power module 300 may correlate with power module 112 of electric vehicle 100. Power module 300 may include a resin base 302 and switching power device 304 embedded in resin base 302. Switching power device 304 may be, for example, an embedded die such as a silicon carbide chip. One or more vias 306 may facilitate electrical connections (e.g., route electricity) between switching power device 304 and conductive (e.g., copper) layers 308, 310 and 312. One or more vias 306 may also create thermal paths to dissipate heat from switching power device 304 to a first cooling module 314 and a second cooling module 316. Similarly to power module 112 of FIG. 2A and power module 250 of FIG. 2B, all of the conductive layers 308, 310, 312 may be electrically connected to switching power device 304. First cooling module 314 and second cooling module 316 may directly contact power module 300. Instead of electrically isolating first cooling module 314 and/or second cooling module 316 from switching power device 304 of power module 300, power module 300, first cooling module 314, and second cooling module 316 in combination may be electrically isolated from the rest of the system (e.g., the rest of traction inverter 102).

First cooling module 314 may include a fin structure 318 that is directly attached to power module 300 (e.g., conductive layer 308) by soldering joints 320 at a first end 326. The fin structure 318 may be made of copper or any other conductive material. First cooling module 314 may include an epoxy mold cover 322 surrounding fin structure 318 and the interface between first cooling module 314 and power module 300. In this way, because first cooling module 314 is directly attached (e.g., electrically connected) to power module 300, the epoxy mold cover 322 may satisfy high-voltage requirements of electrically isolating the connections to switching power device 304. First cooling module 314 may include a dielectric fluid 324 surrounding fin structure 318 within epoxy mold cover 322. Dielectric fluid 324 may be a dielectric fluid or any cooling medium such as water-glycol. Because both dielectric fluid 324 and fin structure 318 are within epoxy mold cover 322, dielectric fluid 324 may be in direct contact with fin structure 318. Power module 300 may interface with second cooling module 316 at a second end 328 of the power module 300 to achieve double-sided cooling. Fin structure 318 may be directly attached to the conductive layer 308 (or conductive layer 312 as depicted in FIG. D) by soldering, sintering, and/or welding.

Second cooling module 316 may include a fin structure 330 that is directly attached to power module 300 (e.g., conductive layer 312) by welding joints 332 at the second end 328. The fin structure 330 may be made of copper, for example. Second cooling module 316 may include one or more cooling channels 334 that supplies a dielectric fluid (e.g., cooling medium). In an example, the cooling medium is water-glycol. An epoxy mold 336 may encapsulate fin structure 330, welding joints 332 (e.g., the interface between power module 300 and second cooling module 316), and one or more cooling channels 334. While first cooling module 314 may include dielectric fluid 324 surrounding fin structure 318, second cooling module 316 instead includes one or more cooling channels 334 to provide multiple channels with a cooling medium through fin structure 330. Thus, the cooling medium in one or more cooling channels 334 may not be in direct contact with fin structure 330 (e.g.., epoxy mold 336 may be provided between the cooling medium and fin structure 330). Similar to first cooling module 314, the epoxy mold 336 of second cooling module 316 may satisfy high-voltage requirements of electrically isolating the connections to switching power device 304.

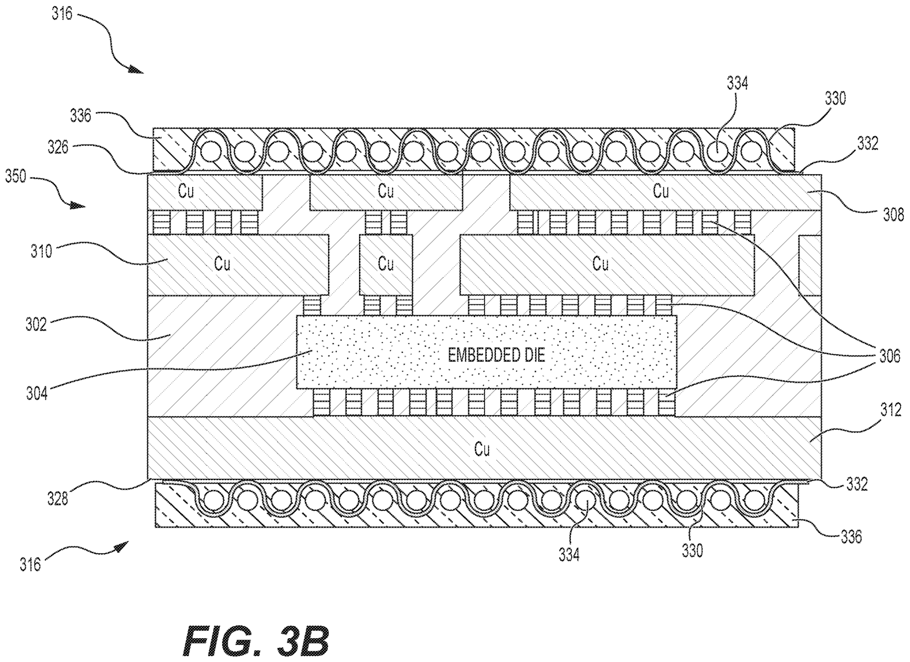

FIG. 3B depicts an exemplary double-sided cooled PCB-based power module with direct multi-channel cooling, according to one or more embodiments. Power module 350 of FIG. 3B may be the same as power module 300 of FIG. 3A. Power module 350 may interface with second cooling module 316 at first end 326, and second cooling module 316 at second end 328.

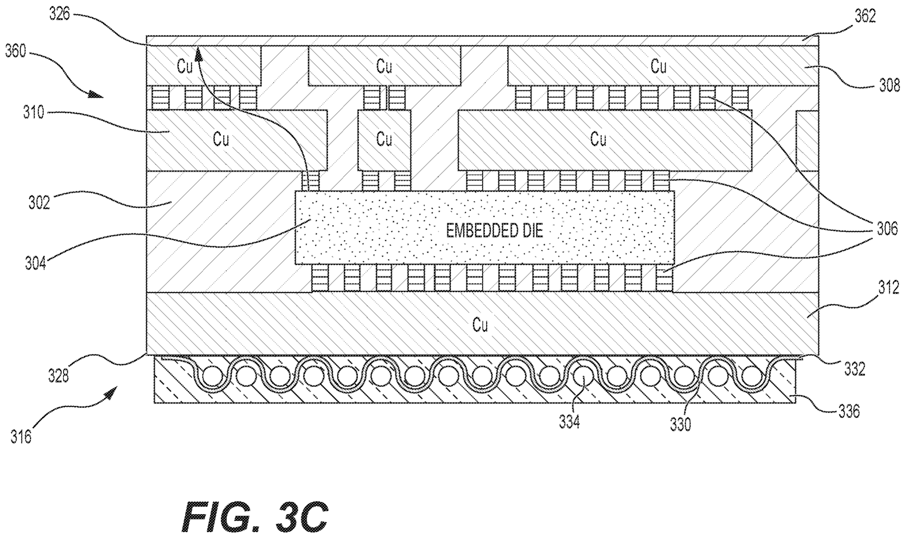

FIG. 3C depicts an exemplary single-sided cooled PCB-based power module with direct multi-channel cooling, according to one or more embodiments. Power module 360 of FIG. 3C may be similar to power module 300 of FIG. 3A. Power module 360 may interface with second cooling module 316 at second end 328 as a single (i.e. one and only one) cooling module. A solder mask layer 362 may be attached to power module 360 at first end 326 to meet high-voltage requirements by electrically isolating other components of traction inverter 102 and electric vehicle 100 from switching power device 304.

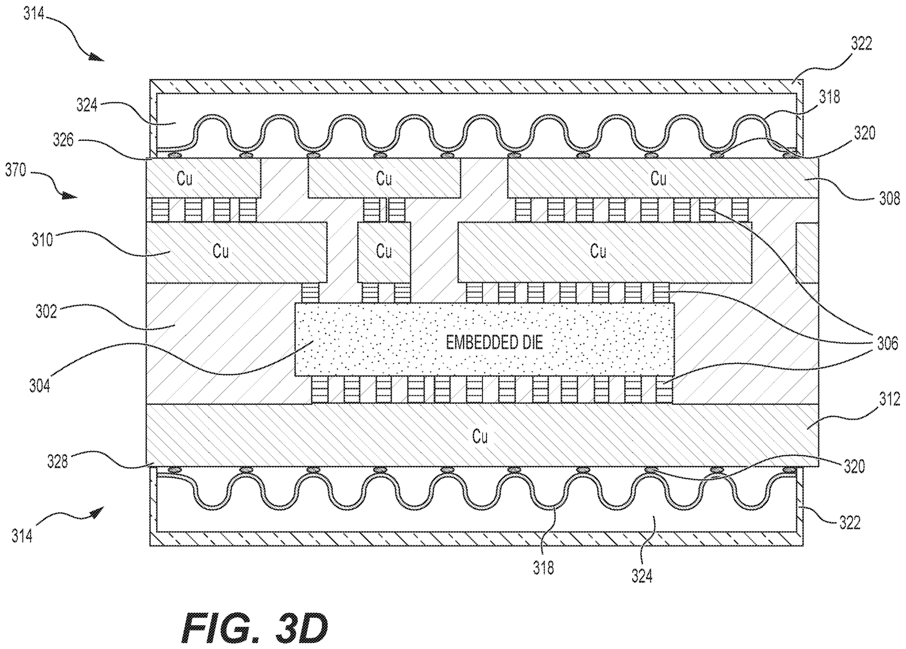

FIG. 3D depicts an exemplary double-sided cooled PCB-based power module with direct single-channel cooling, according to one or more embodiments. Power module 370 of FIG. 3D may be the same power module as power module 300 of FIG. 3A. Power module 370 may interface with first cooling module 314 at first end 326 and first cooling module 314 at second end 328.

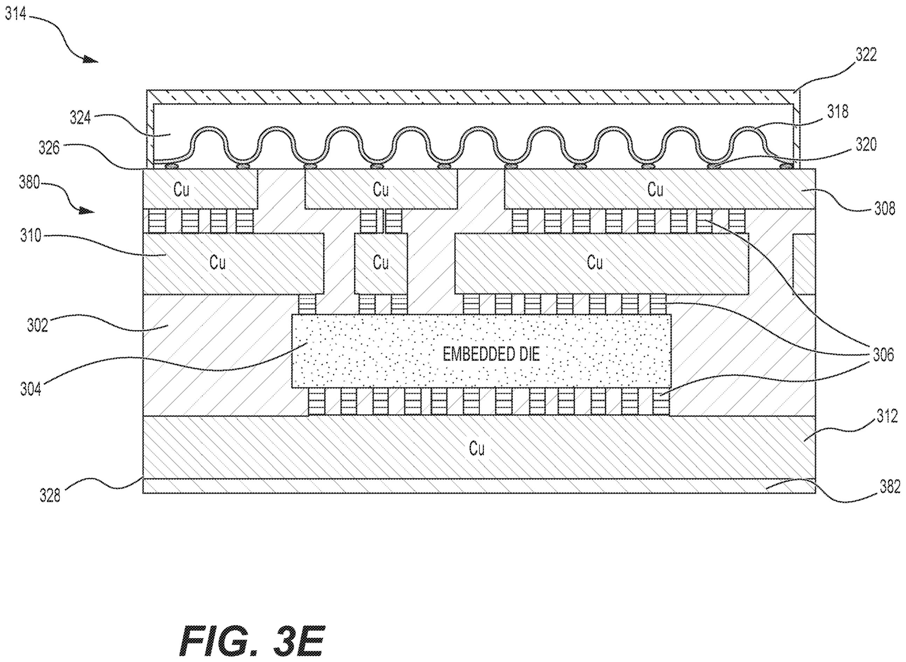

FIG. 3E depicts an exemplary single-sided cooled PCB-based power module with direct single-channel cooling, according to one or more embodiments. Power module 380 of FIG. 3E may be similar to power module 300 of FIG. 3A. Power module 380 may interface with first cooling module 314 at first end 326 as a single (i.e. one and only one) cooling module. A solder mask layer 382 may be attached to power module 380 at second end 328 to meet high-voltage requirements by electrically isolating other components of traction inverter 102 and electric vehicle 100 from switching power device 304.

One or more embodiments may include a single-sided or double-sided cooled PCB power module with an embedded chip attached to a copper core. One or more embodiments may include a single-sided or double-sided cooled PCB power module with an embedded chip. One or more embodiments may provide a cooling module as a heat sink with a cover and a plurality of fins. One or more embodiments may provide a cooling module that is actively cooled with a dielectric fluid or any cooling medium such as water-glycol. One or more embodiments may provide a cooling module that is passively cooled with air. One or more embodiments may include a cooling module with fins directly soldered, sintered, and/or welded to the PCB and covered with an epoxy mold. One or more embodiments may include a cooling module that is encapsulated in an epoxy mold with cooling channels. One or more embodiments include a power module without an internal isolation layer that interrupts the electrical path to the cooling module. One or more embodiments may provide an isolation layer external to the power module to allow for double-side cooling. One or more embodiments may directly connect the thermal paths of the power module to the cooling module.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising a power conversion unit, wherein the power conversion unit includes:
a power module; and
a first cooling module configured to extract heat from the power module, wherein
the power module includes:
a printed circuit board;
a switching power device embedded within the printed circuit board; and
a first external isolation layer external to the printed circuit board,
wherein the first cooling module directly contacts the first external isolation layer.

2. The system of claim 1, wherein the first external isolation layer includes a thermal interface material layer and a ceramic isolation layer.

3. The system of any one of claims 1 to 2, further comprising:
a second cooling module configured to extract heat from the power module, and
wherein the power module includes a second external isolation layer external to the printed circuit board.

4. The system of claim 3, wherein a first side of the first external isolation layer is in contact with the first cooling module and a second side of the first external isolation layer opposite to the first side is in contact with a first end of the printed circuit board, and wherein a first side of the second external isolation layer is in contact with the second cooling module and a second side of the second external isolation layer opposite to the first side is in contact with a second end of the printed circuit board.

5. The system of claim 4, wherein the power module includes a first solder mask layer in contact with the first end of the printed circuit board and a second solder mask layer in contact with the second end of the printed circuit board, and wherein the first external isolation layer is within and/or exterior to the first solder mask layer and the second external isolation layer is within and/or exterior to the second solder mask layer.

6. The system of any one of claims 1 to 5, wherein the first cooling module cools the power module via air cooling; and/or
wherein the first cooling module cools the power module via liquid cooling, wherein the liquid cooling preferably includes water-glycol.

7. The system of any one of claims 1 to 6, wherein the printed circuit board includes a plurality of conductive layers, and wherein each conductive layer of the plurality of conductive layers is electrically connected to the switching power device; and,
wherein, preferably, the power module is cooled via double-side cooling.

8. The system any one of claims 1 to 7, further comprising:
a battery connected to the power conversion unit, and
a motor configured to rotate based on power received from the power conversion unit, wherein the system is provided as a vehicle.

9. A system comprising a first cooling module configured to extract heat from a power module, wherein the power module includes a printed circuit board and a switching power device embedded within the printed circuit board, wherein the power module includes a first external isolation layer external to the printed circuit board, and wherein the first cooling module directly contacts the first external isolation layer.

10. The system of claim 9, wherein the printed circuit board includes a plurality of conductive layers, and wherein each conductive layer of the plurality of conductive layers is electrically connected to the switching power device;
and/or
wherein the first cooling module cools the power module via liquid cooling.

11. The system of claim 10, further comprising a second cooling module configured to extract heat from the power module, wherein the power module includes a second external isolation layer external to the printed circuit board, wherein a first side of the first external isolation layer is in contact with the first cooling module and a second side of the first external isolation layer opposite to the first side is in contact with a first end of the printed circuit board, and wherein a first side of the second external isolation layer is in contact with the second cooling module and a second side of the second external isolation layer opposite to the first side is in contact with a second side of the printed circuit board.

12. A method comprising:
embedding a switching power device within a printed circuit board of a power module; and
extracting heat from the power module via a first cooling module, wherein the power module includes a first external isolation layer external to the printed circuit board, and wherein the first cooling module directly contacts the first external isolation layer.

13. The method of claim 12, wherein the printed circuit board includes a plurality of conductive layers, and wherein each conductive layer of the plurality of conductive layers is electrically connected to the switching power device.

14. The method of claim 13, further comprising:
extracting heat from the power module via a second cooling module, wherein the first cooling module is provided at a first end of the power module and wherein the second cooling module is provided at a second end of the power module opposite to the first end, and wherein the power module includes a second external isolation layer external to the printed circuit board;
and/or
wherein the first cooling module cools the power module via air cooling.

15. The method of claim 13 or 14, wherein a first side of the first external isolation layer is in contact with the first cooling module and a second side of the first external isolation layer opposite to the first side is in contact with the first end of the printed circuit board, and wherein a first side of the second external isolation layer is in contact with the second cooling module and a second side of the second external isolation layer opposite to the first side is in contact with the second end of the printed circuit board.
